# EUROPÄISCHE PATENTSCHRIFT

(11) **EP 2 091 642 B1**
(45) Veröffentlichungstag und Bekanntmachung des Hinweises auf die Patenterteilung: **18.08.2010**
(21) Anmeldenummer: 07818961.0
(22) Anmeldetag: 12.10.2007
(51) Int. Cl.: B01J 3/00, B01J 3/03, C23C 14/56

(54) **BANDSCHLEUSE**
SEALING GATE FOR STRIPS
JOINT POUR BANDE

(30) Priorität: 27.10.2006 DE 102006051395; 28.02.2007 DE 102007009710
(43) Veröffentlichungstag der Anmeldung: 26.08.2009
(73) Patentinhaber: SMS Siemag AG, 40237 Düsseldorf (DE)
(72) Erfinder: KÜMMEL, Lutz, 41363 Jüchen (DE); GRAMER, Andreas, 42655 Solingen (DE); BEHRENS, Holger, 40699 Erkrath (DE); KRETSCHMER, Matthias, 50939 Köln (DE); SOHL, Ralf-Hartmut, 42699 Solingen (DE); DE KOCK, Peter, 46117 Oberhausen (DE)
(74) Vertreter: Klüppel, Walter
(86) Internationale Anmeldenummer: PCT/EP2007/008890
(87) Internationale Veröffentlichungsnummer: WO 2008/049523

(56) Entgegenhaltungen:
- DE-A1- 4 418 383
- DE-A1- 19 960 751
- DE-C1- 4 240 490

## Beschreibung

Die Erfindung betrifft eine Bandschleuse zur Abdichtung eines ersten Raumes gegenüber einem zweiten Raum, wobei beide Räume von einem Band, insbesondere einem Metallband, passiert werden und wobei zur Abdichtung der Räume mindestens ein Dichtmittel vorgesehen ist.

Bei der Herstellung und Veredelung eines Metallbandes, insbesondere eines Stahlbandes, ist es gelegentlich erforderlich, Prozesse in druckreduzierter Umgebung vorzunehmen (Vakuumprozess). Hierzu wird das Band in einen Raum geführt, der ein gegenüber dem Umgebungsdruck abgesenktes Druckniveau aufweist. Um einen kontinuierlichen Prozess zu erreichen, sind hierfür Bandschleusen der genannten Art notwendig, die das Band zwischen den Räumen unterschiedlichen Druckniveaus abdichten. Die Schleusen dienen also primär zum Aufbau einer Druckdifferenz zwischen zwei Bandbehandlungsbereichen.

Gattungsgemäße Bandschleusen sind beispielsweise aus der DE 44 18 383 C2 und aus der DE 199 60 751 A1 bekannt. Dort ist beschrieben, dass sich an einer Schleusenstufe zwei Abdichtrollen an das Band anlegen, um es abzudichten, und zwar eine erste Abdichtrolle auf der Oberseite und eine zweite Abdichtrolle auf der Unterseite des Bandes.

Derartige Bandschleusen kommen generell für Produkte mit einem Breiten- zu Dickenverhältnis von wesentlich größer als 1 zum Einsatz. Sie können auch eingesetzt werden, um Kammern gegeneinander abzudichten, in denen unterschiedliche Medien zur Bandbehandlung eingesetzt werden.

Die Abdichtung mittels Abdichtrollen ist aufgrund der erforderlichen Lagerung der Rollen relativ aufwändig und damit kostspielig. Dies gilt insbesondere, wenn sich chargenbedingt die Breite und/oder Dicke des abzudichtenden Bandes ändert. Die Anpassung der Bandschleuse an Bänder unterschiedlicher Breite und Dicke ist aufwändig. Durch die Einstellung wird teilweise auch die Qualität der Abdichtung negativ beeinflusst.

Der vorliegenden Erfindung liegt daher die Aufgabe zugrunde, eine Bandschleuse der eingangs genannten Art so weiterzubilden, dass diesbezüglich eine Verbesserung erreicht werden kann. Die Schleuse soll also eine verbesserte Dichtwirkung aufweisen und in einfacher Weise auf Bänder verschiedener Breite und Dicke einstellbar sein.

Die Lösung dieser Aufgabe durch die Erfindung ist dadurch gekennzeichnet, dass das Dichtmittel mindestens zwei relativ zueinander verschiebliche Blendenelemente aufweist, die zumindest eine Dichtfläche haben, die der Randkontur des abzudichtenden Bandes angepasst ist.

Bevorzugt sind mindestens zwei der Blendenelemente plattenförmig ausgebildet und parallel zueinander aneinander liegend angeordnet. Die einzelnen plattenförmig ausgebildeten Blendenelemente liegen dabei dichtend aneinander an. Zumindest ein Teil der Blendenelemente können mit Stellelementen in Verbindung stehen, um ein Blendenelement in eine Richtung senkrecht zur Förderrichtung des Bandes zu verstellen.

Erfindungsgemäß werden also mehrere Blendenelemente so an das Band herangefahren, dass sich für das Band ein Durchtrittskanal entsprechend seiner Form ergibt. Hierfür weisen die Blendenelemente mindestens eine Dichtfläche auf, die der Form des Bandes entspricht.

Eine bevorzugte Ausführungsform sieht vor, dass zwei zueinander verschiebliche Blendenelemente vorgesehen sind, die jeweils eine rechteckförmige Ausnehmung zum Durchtritt des Bandes aufweisen. Damit lassen sich - bei entsprechender Verschiebung der Blendenelemente - beliebige rechteckige Durchtrittskanäle für das Band schaffen.

Eine alternative Ausführungsform sieht vor, dass zwei zueinander verschiebliche Blendenelemente vorgesehen sind, die jeweils zwei senkrecht zueinander angeordnete Dichtflächen aufweisen. Im Zusammenwirken dieser Blendenelemente kann ebenfalls ein rechteckiger Durchtrittskanal für das Band erzeugt werden, der genau der Querschnittsform des Bands entspricht.

Eine weitere alternative Ausgestaltung der Erfindung sieht vor, dass vier zueinander verschiebliche Blendenelemente vorgesehen sind, die jeweils eine gerade verlaufende Dichtfläche aufweisen. Hiernach werden also insgesamt vier Teilblenden so zusammengefahren, dass sich ein rechteckiger Durchtrittskanal für das Band ergibt.

Eines der Blendenelemente kann auch als Rolle ausgebildet sein.

Zumindest eines der Blendenelemente kann mittels mindestens eines Federelements mit seiner Dichtfläche auf die Bandoberfläche gedrückt werden.

Zur genauen Führung des Bandes sieht eine Weiterbildung vor, dass mindestens eine Führungsrolle vorhanden ist, die an der Bandkante anläuft und das Band relativ zur Bandschleuse führt.

Eine spezielle Ausgestaltung der Erfindung sieht vor, dass mindestens ein Blendenelement mit Mitteln zur Anpassung der Wirkhöhe bzw. Wirkbreite ausgestattet ist. Dabei ist bevorzugt vorgesehen, dass die Mittel zur Anpassung der Wirkhöhe bzw. Wirkbreite durch zwei Blendenteile realisiert werden, die an schräg zur Förderrichtung des Bandes geschnittenen Anlageflächen aneinander liegen; dabei ist mindestens eines der Teile durch ein Bewegungselement in Förderrichtung des Bandes positionierbar.

Um bei Verschleiß in schneller und einfacher Weise eine neue Blende mit einer neuen Dichtfläche in den Einsatz bringen zu können, hat es sich bewährt, wenn ein Wechselmittel vorhanden ist, mit dem ein Blendenelement quer zur Förderrichtung des Bandes in den Dichtbereich eingefahren oder herausgefahren werden kann.

Zur Stabilisierung kann das Band in Förderrichtung über zwei Rollen so geführt werden, dass sich eine zweimalige Bandumlenkung vor und hinter den Blendenelementen ergibt.

Um höhere Druckdifferenzen aufzubauen, hat es sich bewährt, wenn mehrere Schleusenstufen in Bandlaufrichtung hintereinander angeordnet sind.

Die Bandschleuse wird bevorzugt eingesetzt, um zur Abdichtung eines ersten Raumes mit einem ersten Druckniveau gegenüber einem zweiten Raum mit einem zweiten, vom ersten Druckniveau abweichenden Druckniveau zu dienen. Sie kann aber auch bei Druckgleichheit der Räume eingesetzt werden, wenn in diesen unterschiedliche Medien gegeneinander abgedichtet werden müssen; in diesem Falle ist also vorgesehen, dass die Bandschleuse zur Abdichtung eines ersten Raumes mit einem ersten Prozessmedium gegenüber einem zweiten Raum mit einem zweiten, vom ersten Prozessmedium verschiedenen Prozessmedium eingesetzt wird.

In der Zeichnung sind Ausführungsbeispiele der Erfindung dargestellt. Es zeigen:
- Fig. 1: die wesentlichen Teile einer Bandschleuse in Förderrichtung des ab- zudichtenden Bandes gesehen,
- Fig. 2: die zu Fig. 1 entsprechende Draufsicht auf die Bandschleuse,
- Fig. 3: eine erste alternative Ausführungsform der Erfindung in der Darstel- lung gemäß Fig. 1,
- Fig. 4: die zu Fig. 3 entsprechende Draufsicht auf die Bandschleuse,
- Fig. 5: eine zweite alternative Ausführungsform der Erfindung in der Darstel- lung gemäß Fig. 1,
- Fig. 6: die zu Fig. 5 entsprechende Draufsicht auf die Bandschleuse,
- Fig. 7: eine dritte alternative Ausführungsform der Erfindung in der Darstel- lung gemäß Fig. 1,
- Fig. 8: die zu Fig. 7 entsprechende Draufsicht auf die Bandschleuse,
- Fig. 9a: eine Bandschleuse mit zwei Schleusenstufen in Richtung quer zur Förderrichtung des Bandes betrachtet,
- Fig. 9b: die zu Fig. 9a zugehörige Ansicht in Förderrichtung des Bandes ge- sehen,
- Fig. 9c: die zu Fig. 9a zugehörige Draufsicht,
- Fig. 10a: eine alternative Ausgestaltung der Bandschleuse, in Richtung quer zur Förderrichtung des Bandes betrachtet,
- Fig. 10b: die zu Fig. 10a zugehörige Ansicht in Förderrichtung des Bandes gesehen,
- Fig. 11a: eine alternative Ausgestaltung der Bandschleuse in Förderrichtung des Bandes gesehen,
- Fig. 11b: die zu Fig. 11 a zugehörige Ansicht quer zur Förderrichtung des Ban- des gesehen,
- Fig. 11c: die zu Fig. 11a zugehörige Draufsicht,
- Fig. 12: eine Bandschleuse mit einem Wechselmittel für ein Blendenelement und
- Fig. 13: eine Bandschleuse mit davor und dahinter angeordneten Rollen für die Umlenkung des abzudichtenden Bandes.

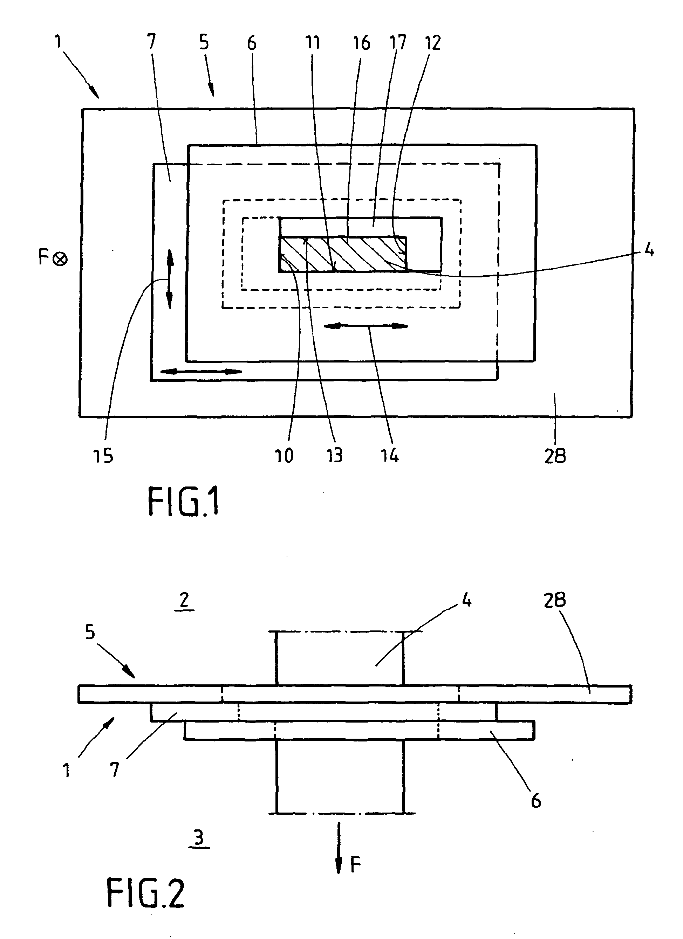

In den Figuren 1 und 2 ist eine Bandschleuse 1 zu sehen, die einen ersten Raum 2 gegenüber einem zweiten Raum 3 abdichtet. Zwischen den beiden Räumen 2, 3 liegt ein Druckunterschied vor, der zu seiner Aufrechterhaltung die Bandschleuse 1 erforderlich macht. Die Bandschleuse 1 lässt ein kontinuierliches Hindurchfahren eines Bandes 4 zu, das die Bandschleuse 1 in Förderrichtung F passiert.

Zur Abdichtung des Bandes 4 ist ein Dichtmittel 5 vorgesehen. Das Dichtmittel 5 besteht vorliegend aus zwei Blendenelementen 6 und 7, die plattenförmig ausgebildet sind und jeweils eine rechteckförmige Ausnehmung 16 und 17 aufweisen. Die Abmessungen der rechteckförmigen Ausnehmungen 16, 17 sind so gewählt, dass die Breite und die Höhe größer sind als die maximal auftretende Breite bzw. Höhe des abzudichtenden Bandes 4.

Das Blendenelement 6 hat zwei Dichtflächen 10 und 11; das Blendenelement 7 hat zwei Dichtflächen 12 und 13. Die beiden Blendenelemente 6, 7 liegen, wie es in Fig. 2 gesehen werden kann, dichtend aufeinander. Das eine Blendenelement 7 liegt dabei wiederum an einer plattenförmig ausgebildeten Kammertrennwand 28 an.

Nur schematisch sind Stellelemente 14 und 15 in Fig. 1 eingetragen, die dazu dienen, die Blendenelemente 6, 7 in ihrer Plattenebene zu verschieben. Dies erfolgt so, bis die jeweiligen Dichtflächen 10, 11, 12, 13 an dem Band 4 anliegen, wodurch das Band 4 dann zwischen den Räumen 2, 3 abgedichtet ist. Die Abdichtung erfolgt also durch einen formkongruenten Kontaktbereich zwischen den Blenden 6, 7 und dem Band 4. Zur Anpassung an ein aktuell abzudichtendes Band 4 werden die Blendenelemente 6, 7 gemäß der Breite und Dicke des Bandes 4 an das Band 4 herangefahren. Die Blendenelemente 6, 7 können, was nicht dargestellt ist, durch zusätzliche, der Bandkontur folgende Führungselemente (z. B. Führungsrollen) positioniert werden. Die Abdichtung der Blendenelemente 6, 7 untereinander erfolgt über den flächigen Kontakt bzw. separate Dichtelemente, insbesondere Dichtflächen (nicht dargestellt). Die Abdichtung der Blendenelemente 6, 7 zur Kammertrennwand 28 erfolgt ebenfalls über Kontakt- bzw. Dichtelemente (Dichtflächen).

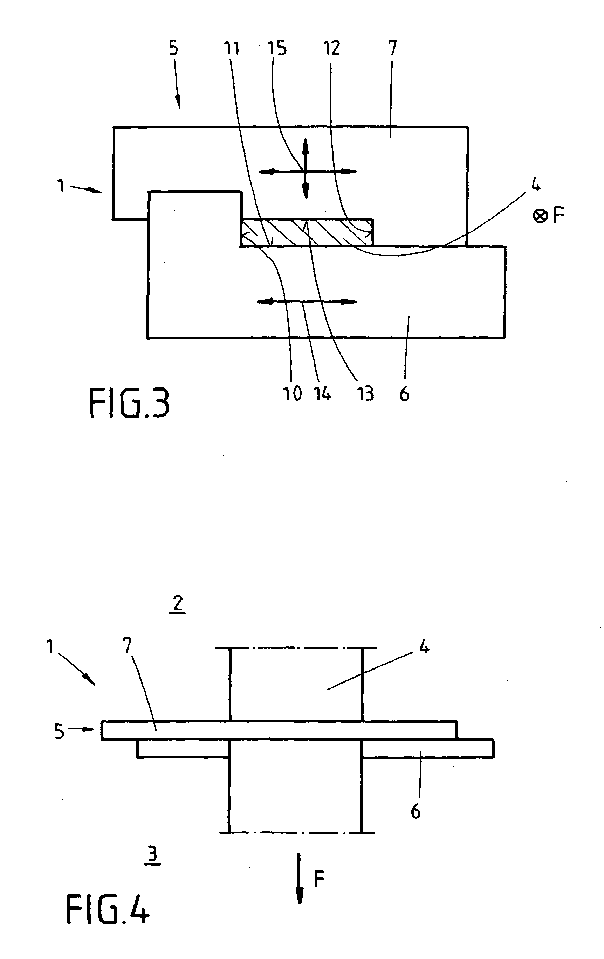

Eine zu Fig. 1, 2 alternative Ausgestaltung der Erfindung ist in den Figuren 3 und 4 dargestellt. Hier sind wieder zwei Blendenelemente 6, 7 vorhanden, die jetzt allerdings jeweils einen Ausschnitt aufweisen, der zwei zueinander senkrechte Dichtflächen 10, 11 (für das Blendenelement 6) bzw. 12, 13 (für das Blendenelement 7) definiert. Analog zu den Ausführungen im Zusammenhang mit den Figuren 1 und 2 ist auch hier vorgesehen, dass die beiden Blendenelemente 6, 7 mittels Stellelementen 14, 15 so verfahren werden, dass sich insgesamt ein Durchtrittskanal für das Band 4 ergibt, der genau der Querschnittsform des Bandes 4 entspricht.

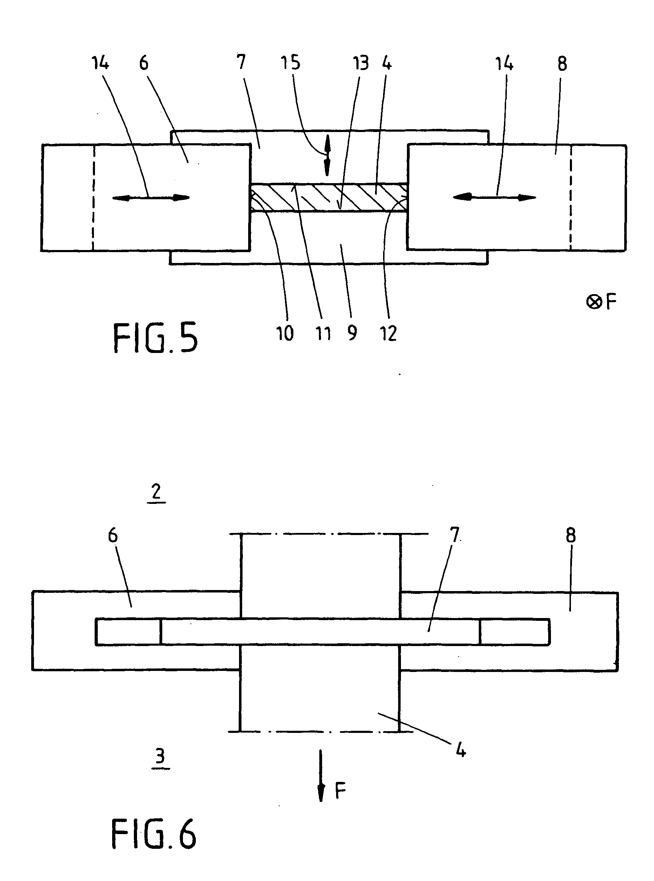

Die weitere alternative Ausführungsform gemäß der Figuren 5 und 6 sieht vier Blendenelemente 6, 7, 8, 9 vor, die jeweils (abgesehen von dem ortsfesten Blendenelement 9) mittels Stellelementen 14, 15 in die Position verfahren werden, dass ihre jeweiligen Dichtflächen 10, 11, 12, 13 den Durchtrittskanal für das Band 4 definieren, der wieder genau dem Querschnitt des Bandes 4 entspricht.

Wie aus der Draufsicht gemäß Fig. 6 hervorgeht, sind die beiden Blendenelemente 6 und 8 im Schnitt U-förmig ausgebildet; in den sich ergebenden Zwischenraum zwischen den beiden Schenkeln der U-förmigen Struktur sind die Blendenelemente 7 bzw. 9 eingesetzt.

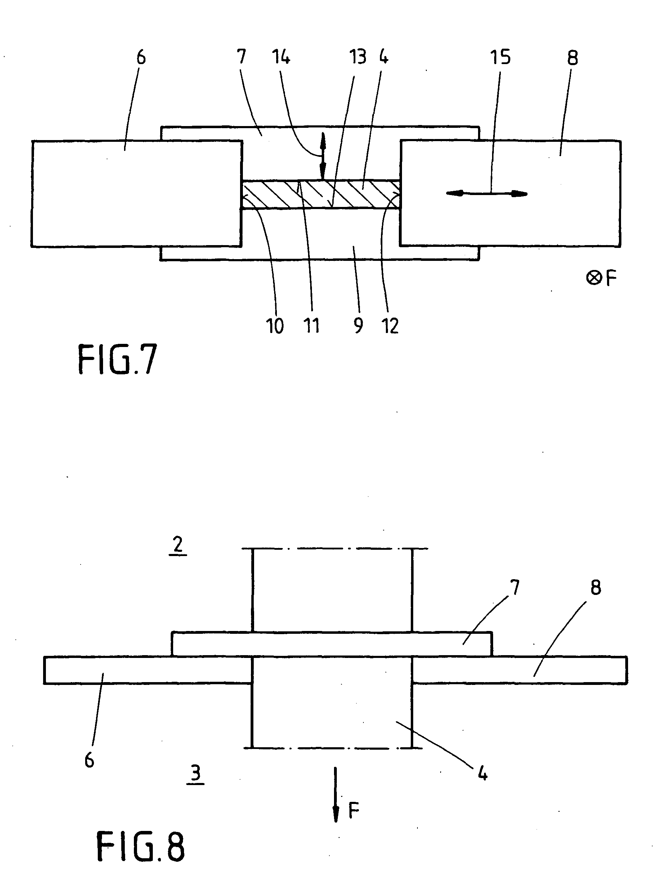

Die Figuren 7 und 8 zeigen eine weitere alternative Ausgestaltung der Dichtmittel mit vier Blendenelementen 6, 7, 8, 9.

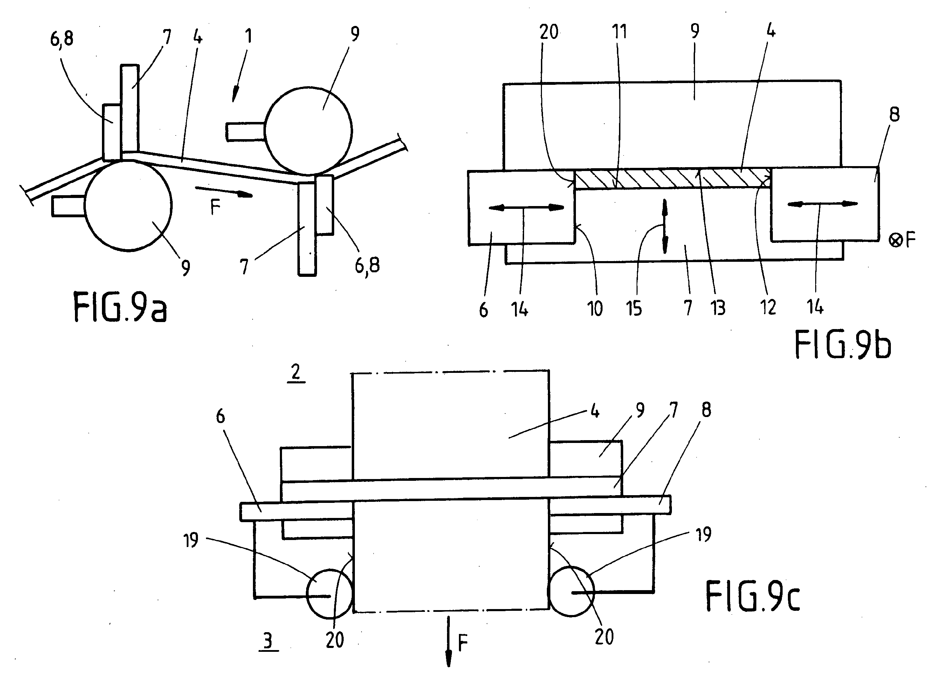

Die Figuren 9a, 9b und 9c zeigen in verschiedenen Ansichten eine Bandschleuse 1 mit zwei in Förderrichtung F hintereinander angeordneten Schleusenstufen. Eines der Blendenelemente, nämlich das Blendenelement 9, ist hier als Rolle ausgebildet. Die Rolle 9 wirkt mit drei plattenförmig ausgebildeten Blendenelementen 6, 7, 8 zusammen, um in der erläuterten Weise den rechteckigen Durchtrittskanal für das Band 4 zu definieren.

In Fig. 9c sind zwei seitlich am Band 4 angeordnete Führungsrollen 19 zu sehen, die auf der Bandkante 20 anlaufen und damit das Band 4 relativ zum Dichtmittel zentrieren. Die Führungsrollen 19 sind gemäß dieser Figur ortsfest an den Blendenelementen angeordnet. Hierdurch können die Blendenelemente 6, 7 nach der aktuellen Bandkantenposition ausgerichtet werden.

Die Führungsrollen 19 können aber auch ortsfest an der Bandschleuse bzw. deren Grundrahmen befestigt sein und das Band in der Mitte der Bandschleuse führen.

Beide Varianten sind möglich, jedoch ist die letztgenannte insofern von Vorteil, als dass das Band in der Mitte gehalten wird (Bandmittenregelung) und damit die Blende nur kleinen Schwankungen nachgeführt werden muss. Hierbei treten kleinere Kräfte auf als bei der ersten Lösung.

Wie in Fig. 9a gesehen werden kann, erfolgt zur besseren Bandführung hier eine Teilumschlingung des Bandes durch die Rollen 9, so dass Querbögen bzw. Planheitsfehler unterdrückt werden können.

Auch hier können die Blendenelemente durch zusätzliche, der Bandkontur folgende Führungselemente positioniert werden.

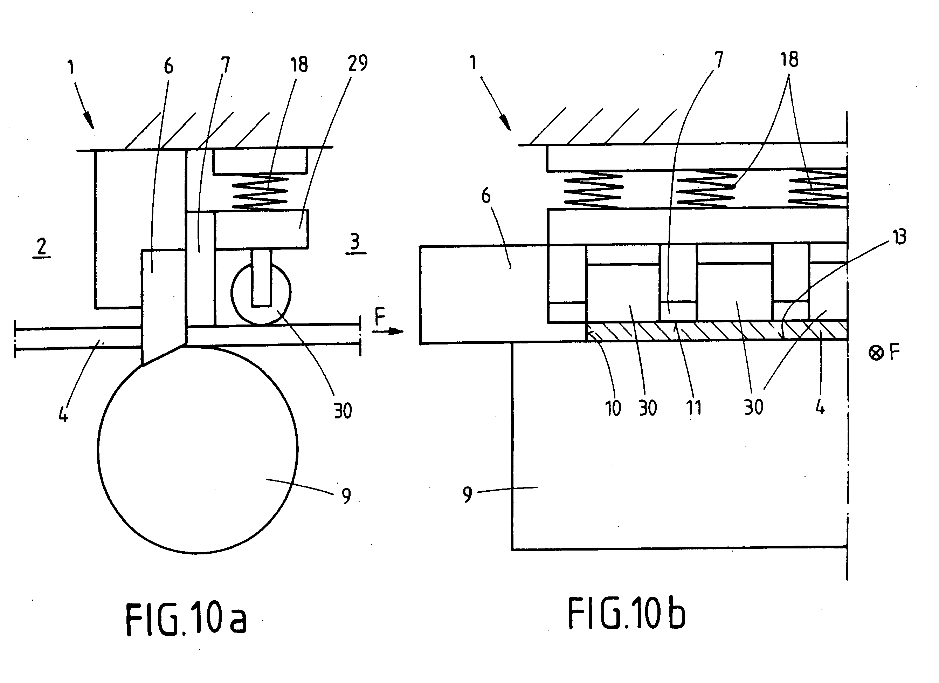

In den Figuren 10a und 10b ist zu sehen, dass die Blendenelemente (hier dargstellt für das Blendenelement 7) über Federelemente 18 in Richtung Bandoberfläche vorgespannt werden können, um den Grad der Dichtigkeit zu erhöhen. Hier ist eine Traverse 29 federvorgespannt durch die Federelemente 18 angeordnet, wobei die Traverse 29 das Blendenelement 7 trägt. Die Traverse 29 liegt mittels einer Anzahl Rollen 30 in definiertem Abstand zur Bandoberfläche, wodurch auch die Position des Blendenelements 7 definiert wird. Die Traverse 29 passt sich über die Federvorspannung der Federelemente 18 an die aktuelle Bandkontur und/oder Banddicke an. Das Blendenelement 7 folgt der Traverse 29. Hierdurch ist eine Reduzierung des Verschleißes und damit eine Erhöhung der Standzeit der Dichtfläche 11 des Blendenelements 7 möglich.

Die Bandbreitenabdichtung erfolgt über seitlich verschiebbare Blenden.

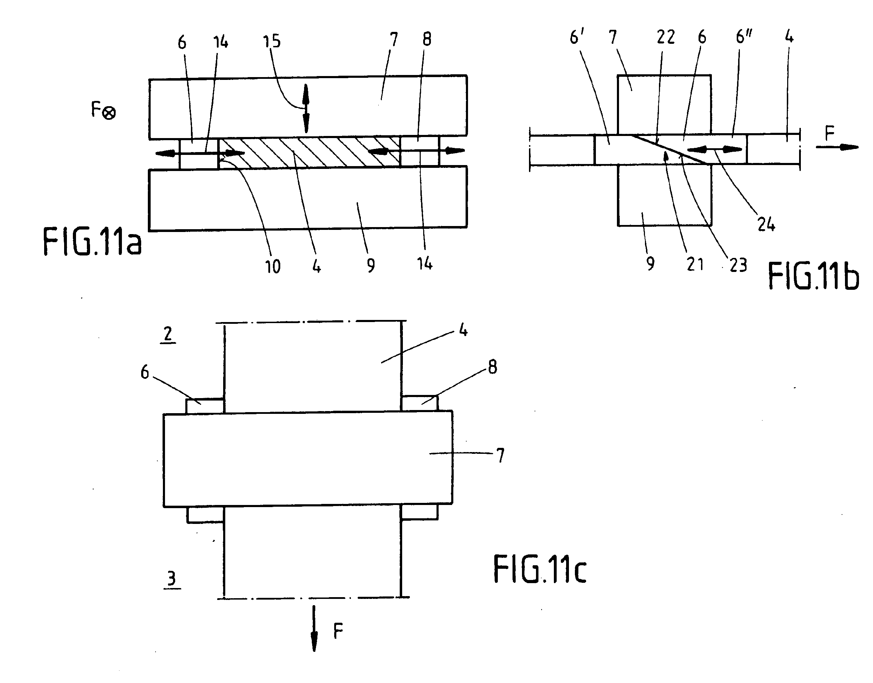

Die Figuren 11a, 11b und 11c zeigen eine Ausgestaltung der Erfindung, bei der Mittel 21 zur Anpassung der Wirkhöhe bzw. Wirkbreite eines Blendenelements vorgesehen sind. Wie in der Zusammenschau der Figuren zu erkennen ist, ist die Blende 6 hier zweiteilig ausgebildet, d. h. sie hat ein erstes Blendenteil 6' und ein zweites Blendenteil 6". Wie aus Fig. 11b hervorgeht, sind die beiden Teile 6', 6" unter einem flachen Winkel zur Förderrichtung F geschnitten ausgebildet, d. h. es ergeben sich Anlageflächen 22 und 23, an denen die Teile 6', 6" aneinander liegen. Weiterhin ist ein Bewegungselement 24 schematisch angedeutet, mit dem das eine Teil 6" relativ zum anderen Teil 6' in Förderrichtung F bewegt werden kann. Über den schrägen Verlauf der Anlageflächen 22, 23 ändert sich damit die effektive Wirkhöhe der Blende 6, so dass sie auf eine gewünschte Höhe eingestellt werden kann. Eine Anpassung der Blende 6 an die Dicke des Bandes 4 wird möglich.

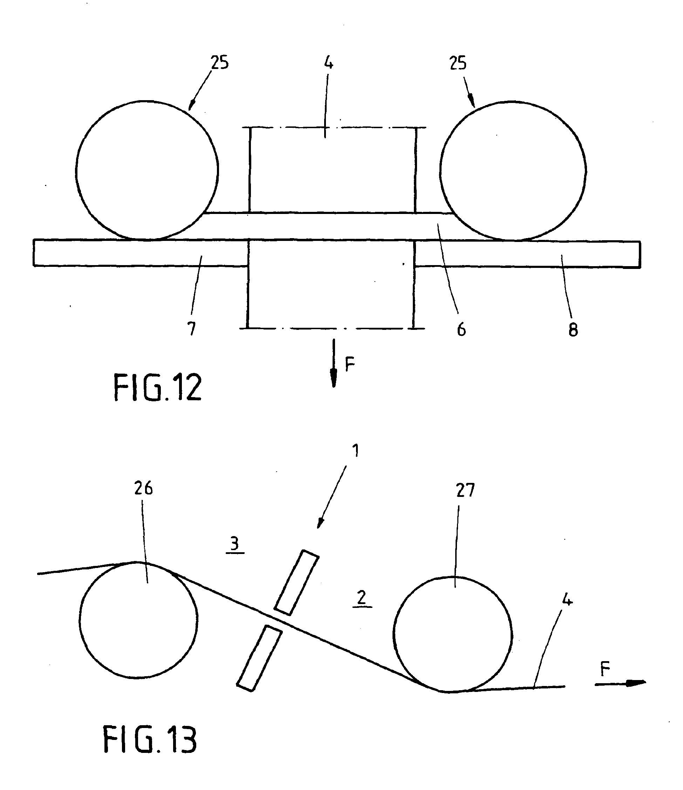

In Fig. 12 ist ein Wechselmittel 25 skizziert, mit dem es möglich ist, im laufenden Betrieb ein Blendenelement 6 zu ersetzen. Ziel dieser Ausführungsform der Erfindung ist also ein Wechsel der Dichtung bei laufendem Prozess bzw. die Minimierung von Stillstandzeiten, wenn ein Blendenelement verschleißbedingt ersetzt werden muss. Das Blendenelement mit der verschlissenen Dichtfläche kann seitlich aus dem Arbeitsbereich der Bandschleuse herausgezogen werden. Auf der anderen Seite kann ein neues Blendenelement zugeführt werden. Der Wechsel kann insbesondere auch bei bestehender Druckdifferenz zwischen den Räumen 2, 3 durchgeführt werden. Es ist dabei sowohl ein kontinuierliches Wechseln des Blendenelements als auch bei Bedarf ein diskontinuierliches Wechseln möglich. Das erläuterte Wechselmittel ist grundsätzlich für alle Blendenelemente einsetzbar.

In Fig. 13 ist zu sehen, wie eine Bandstabilisierung im Bereich der Bandschleuse 1 durch eine Bandumlenkung erfolgen kann. Durch die beiden Rollen 26 und 27 erfolgt eine zweimalige Umlenkung des Bandes 4. Hierdurch wird das Band in eine Ebene gezogen und zusätzlich zwischen den Rollen durch die Biegung stabilisiert. Die sichtbare Ausbildung von Planheitsfehlern und Querbögen reduziert sich. Daraus folgt eine Reduzierung des Verschleißes an den Dichtelementen und eine Reduzierung der Leckage.

Die Umlenkrollen 26, 27 können zusätzlich zur Bandlagenregelung eingesetzt werden. Mit der Bandlagenregelung kann das Band 4 auch gezielt bewegt werden (Schwärmen). Damit kann der Verschleiß an den Dichtflächen der Blendenelemente über die Bandbreite vergleichmäßigt bzw. minimiert werden. Die Dichtflächen an der Bandkante werden dabei synchron nachgeführt.

Es ergibt sich damit eine einfache und kostengünstig aufgebaute Bandschleuse, die ein gutes Dichtverhalten über Formschluss aufweist. Die erfindungsgemäß vorgesehenen Blendenelemente werden gegeneinander dichtend angeordnet und so verschoben, dass sich ein der Querschnittskontur des Bandes entsprechender Durchtrittskanal ergibt.

Die Anpassung an neue Bandabmessungen kann auf zwei Arten erfolgen: die aktive Anpassung stellt auf eine gesteuerte Anstelländerung der Blendenelemente ab; bei der passiven Anpassung wird das Band durch die Dichtflächen der Blendenelemente in die erforderliche Position gedrückt.

Mit der vorgeschlagenen Lösung können Räume unterschiedlichen Ducks, aber auch Räume gleichen Drucks gegeneinander abgedichtet werden, in denen sich verschiedenen Prozessmedien, insbesondere Prozessgase, aber auch Flüssigkeiten, befinden. Sofern seitliche Rollen vorgesehen werden, die an der Bandkante anlaufen, kann mit diesen eine gute seitliche Führung des Bandes erreicht werden. Auf der Bandoberfläche laufende Rollen können zur Führung von Blendenelementen genutzt werden.

### Bezugszeichenliste:

- 1: Bandschleuse
- 2: erster Raum
- 3: zweiter Raum
- 4: Band
- 5: Dichtmittel
- 6: Blendenelement
- 6': Blendenteil
- 6": Blendenteil
- 7: Blendenelement
- 8: Blendenelement
- 9: Blendenelement
- 10: Dichtfläche
- 11: Dichtfläche
- 12: Dichtfläche
- 13: Dichtfläche
- 14: Stellelement
- 15: Stellelement
- 16: rechteckförmige Ausnehmung
- 17: rechteckförmige Ausnehmung
- 18: Federelement
- 19: Führungsrolle
- 20: Bandkante
- 21: Mittel zur Anpassung der Wirkhöhe bzw. Wirkbreite
- 22: Anlagefläche
- 23: Anlagefläche
- 24: Bewegungselement
- 25: Wechselmittel
- 26: Rolle
- 27: Rolle
- 28: Kammertrennwand
- 29: Traverse
- 30: Rolle

- F: Förderrichtung

## Patentansprüche

1. Bandschleuse (1) zur Abdichtung eines ersten Raumes (2) gegenüber einem zweiten Raum (3), wobei beide Räume (2, 3) von einem Band (4), insbesondere einem Metallband, passiert werden und wobei zur Abdichtung der Räume (2, 3) mindestens ein Dichtmittel (5) vorgesehen ist,
**dadurch gekennzeichnet,**
**dass** das Dichtmittel (5) mindestens zwei relativ zueinander verschiebliche Blendenelemente (6, 7, 8, 9) aufweist, die zumindest eine Dichtfläche (10, 11, 12, 13) haben, die der Randkontur des abzudichtenden Bandes (4) angepasst ist.

2. Bandschleuse nach Anspruch 1,
**dadurch gekennzeichnet,**
**dass** mindestens zwei der Blendenelemente (6, 7, 8, 9) plattenförmig ausgebildet sind und parallel zueinander aneinander liegend angeordnet sind.

3. Bandschleuse nach Anspruch 1 oder 2,
**dadurch gekennzeichnet,**
**dass** zumindest ein Teil der Blendenelemente (6, 7, 8, 9) mit Stellelementen (14, 15) in Verbindung stehen, um ein Blendenelement (6, 7, 8, 9) in eine Richtung senkrecht zur Förderrichtung (F) des Bandes (4) zu verstellen.

4. Bandschleuse nach einem der Ansprüche 1 bis 3,
**dadurch gekennzeichnet,**
**dass** zwei zueinander verschiebliche Blendenelemente (6, 7) vorgesehen sind, die jeweils eine rechteckförmige Ausnehmung (16, 17) zum Durchtritt des Bandes (4) aufweisen.

5. Bandschleuse nach einem der Ansprüche 1 bis 3,
**dadurch gekennzeichnet,**
**dass** zwei zueinander verschiebliche Blendenelemente (6, 7) vorgesehen sind, die jeweils zwei senkrecht zueinander angeordnete Dichtflächen (10, 11, 12, 13) aufweisen.

6. Bandschleuse nach einem der Ansprüche 1 bis 3,
**dadurch gekennzeichnet,**
**dass** vier zueinander verschiebliche Blendenelemente (6, 7, 8, 9) vorgesehen sind, die jeweils eine gerade verlaufende Dichtfläche (10, 11, 12, 13) aufweisen.

7. Bandschleuse nach einem der Ansprüche 1 bis 3,
**dadurch gekennzeichnet,**
**dass** eines der Blendenelemente (9) als Rolle ausgebildet ist.

8. Bandschleuse nach einem der Ansprüche 1 bis 7,
**dadurch gekennzeichnet,**
**dass** zumindest eines der Blendenelemente (6, 7, 8, 9) mittels mindestens eines Federelements (18) mit seiner Dichtfläche (10, 11, 12, 13) auf die Bandoberfläche gedrückt wird.

9. Bandschleuse nach einem der Ansprüche 1 bis 8,
**dadurch gekennzeichnet,**
**dass** mindestens eine Führungsrolle (19) vorhanden ist, die an der Bandkante (20) anläuft und das Band (4) relativ zur Bandschleuse (1) führt.

10. Bandschleuse nach einem der Ansprüche 1 bis 9,
**dadurch gekennzeichnet,**
**dass** mindestens ein Blendenelement (6, 7, 8, 9) mit Mitteln (21) zur Anpassung der Wirkhöhe bzw. Wirkbreite ausgestattet ist.

11. Bandschleuse nach Anspruch 10,
**dadurch gekennzeichnet,**
**dass** die Mittel (21) zur Anpassung der Wirkhöhe bzw. Wirkbreite durch zwei Blendenteile (6', 6") realisiert werden, die an schräg zur Förderrichtung (F) des Bandes (4) geschnittenen Anlageflächen (22, 23) aneinander liegen, wobei mindestens eines der Teile (6', 6") durch ein Bewegungselement (24) in Förderrichtung (F) des Bandes (4) positionierbar ist.

12. Bandschleuse nach einem der Ansprüche 1 bis 11,
**dadurch gekennzeichnet,**
**dass** ein Wechselmittel (25) vorhanden ist, mit dem ein Blendenelement (6, 7, 8, 9) quer zur Förderrichtung (F) des Bandes (4) in den Dichtbereich eingefahren oder herausgefahren werden kann.

13. Bandschleuse nach einem der Ansprüche 1 bis 12,
**dadurch gekennzeichnet,**
**dass** das Band (4) in Förderrichtung (F) über zwei Rollen (26, 27) so geführt wird, dass sich eine zweimalige Bandumlenkung vor und hinter den Blendenelementen (6, 7, 8, 9) ergibt.

14. Bandschleuse nach einem der Ansprüche 1 bis 13,
**dadurch gekennzeichnet,**
**dass** mehrere Schleusenstufen in Bandlaufrichtung hintereinander angeordnet sind.

15. Bandschleuse nach einem der Ansprüche 1 bis 14,
**dadurch gekennzeichnet,**
**dass** sie zur Abdichtung eines ersten Raumes (2) mit einem ersten Druckniveau gegenüber einem zweiten Raum (3) mit einem zweiten, vom ersten Druckniveau abweichenden Druckniveau eingesetzt wird.

16. Bandschleuse nach einem der Ansprüche 1 bis 14,
**dadurch gekennzeichnet,**
**dass** sie zur Abdichtung eines ersten Raumes (2) mit einem ersten Prozessmedium gegenüber einem zweiten Raum (3) mit einem zweiten, vom ersten Prozessmedium verschiedenen Prozessmedium eingesetzt wird.

## Claims

1. Strip-sealing gate (1) for sealing a first space (2) relative to a second space (3), wherein a strip (4), particularly a metal strip, passes through the two spaces (2, 3) and wherein at least one sealing means (5) is provided for sealing the spaces (2, 3), **characterised in that** the sealing means (5) comprises at least two screen elements (6, 7, 8, 9) which are displaceable relative to one another and which have at least one sealing surface (10, 11, 12, 13) matched to the edge profile of the strip (4) to be sealed.

2. Strip-sealing gate according to claim 1, **characterised in that** at least two of the screen elements (6, 7, 8, 9) are of plate-shaped construction and are arranged parallel to one another and bearing against one another.

3. Strip-sealing gate according to claim 1 or 2, **characterised in that** at least a part of the screen elements (6, 7, 8, 9) is connected with setting elements (14, 15) in order to adjust a screen element (6, 7, 8, 9) in a direction perpendicular to the conveying direction (F) of the strip (4).

4. Strip-sealing gate according to any one of claims 1 to 3, **characterised in that** two screen elements (6, 7) displaceable relative to one another and each having a rectangular recess (16, 17) for passage of the strip (4) are provided.

5. Strip-sealing gate according to any one of claims 1 to 3, **characterised in that** two screen elements (6, 7) displaceable relative to one another and each having two sealing surfaces (10, 11, 12, 13) arranged perpendicularly to one another are provided.

6. Strip-sealing gate according to any one of claims 1 to 3, **characterised in that** four screen elements (6, 7, 8, 9) displaceable relative to one another and each having a rectilinearly extending sealing surface (10, 11, 12, 13) are provided.

7. Strip-sealing gate according to any one of claims 1 to 3, **characterised in that** one of the screen elements (9) is constructed as a roller.

8. Strip-sealing gate according to any one of claims 1 to 7, **characterised in that** at least one of the screen elements (6, 7, 8, 9) is pressed by its sealing surface (10, 12, 12, 13) by way of at least one spring element (18) onto the strip surface.

9. Strip-sealing gate according to any one of claims 1 to 8, **characterised in that** at least one guide roller (19) which runs against the strip edge (20) and guides the strip (4) relative to the strip-sealing gate (1) is present.

10. Strip-sealing gate according to any one of claims 1 to 9, **characterised in that** at least one screen element (6, 7, 8, 9) is equipped with means (21) for adaptation of the effective height or effective width.

11. Strip-sealing gate according to claim 10, **characterised in that** the means (21) for adaptation of the effective height or effective width are realised by two screen parts (6', 6") which bear against one another at contact surfaces (22, 23) cut at an angle to the conveying direction (F) of the strip (4), wherein at least one of the parts (6', 6") is positionable by a movement element (24) in conveying direction (F) of the strip (4).

12. Strip-sealing gate according to any of claims 1 to 11, **characterised in that** a change-over means (25) by which a screen element (6, 7, 8, 9) can be moved into or out of the sealing region transversely to the conveying direction (F) of the strip (4) is present.

13. Strip-sealing gate according to any one of claims 1 to 12, **characterised in that** the strip (4) is so guided in conveying direction (F) by way of two rollers (26, 27) that a double strip deflection arises in front of and behind the screen elements (6, 7, 8, 9).

14. Strip-sealing gate according to any one of claims 1 to 13, **characterised in that** several strip-sealing gates are arranged in succession in strip running direction.

15. Strip-sealing gate according to any one of claims 1 to 14, **characterised in that** it is used for sealing a first space (2) with a first pressure level relative to a second space (3) with a second pressure level differing from the first pressure level.

16. Strip-sealing gate according to any one of claims 1 to 14, **characterised in that** it is used for sealing a first space (2) with a first process medium relative to a second space (3) with a second process medium differing from the first process medium.

## Revendications

1. Sas à bande (1) pour étancher un premier espace (2) par rapport à un second espace (3), tel que les deux espaces (2, 3) sont traversés par une bande (4), en particulier une bande de métal, et il est prévu au moins un organe d'étanchéité (5) pour étancher les espaces (2, 3),
**caractérisé en ce que**
l'organe d'étanchéité (5) comprend au moins deux éléments formant écrans (6, 7, 8, 9) déplaçables l'un par rapport à l'autre, qui possèdent au moins une surface d'étanchéité (10, 11, 12, 13) qui est ajustée au contour de bordure de la bande à étancher (4).

2. Sas à bande selon la revendication 1,
**caractérisé en ce qu'**au moins deux des éléments formant écrans (6, 7, 8, 9) sont réalisés en forme de plaques et sont agencés de manière à s'appliquer l'un contre l'autre et parallèlement l'un à l'autre.

3. Sas à bande selon la revendication 1 ou 2,
**caractérisé en ce qu'**au moins une partie des éléments formant écrans (6, 7, 8, 9) sont reliés à des éléments de positionnement (14, 15) afin de déplacer un élément formant écran (6, 7, 8, 9) dans une direction perpendiculaire à la direction de convoyage (F) de la bande (4).

4. Sas à bande selon l'une des revendications 1 à 3,
**caractérisé en ce qu'**il est prévu deux éléments formant écrans (6, 7) déplaçables l'un par rapport à l'autre, qui présentent chacun un évidement (16, 17) de forme rectangulaire pour la traversée de la bande (4).

5. Sas à bande selon l'une des revendications 1 à 3,
**caractérisé en ce qu'**il est prévu deux éléments formant écrans (6, 7) déplaçables l'un par rapport à l'autre, qui présentent chacun deux surfaces d'étanchéité (10, 11, 12, 13) agencées perpendiculairement l'une par rapport à l'autre.

6. Sas à bande selon l'une des revendications 1 à 3,
**caractérisé en ce qu'**il est prévu quatre éléments formant écrans (6, 7, 8, 9) déplaçables les uns par rapport aux autres, qui présentent chacun une surface d'étanchéité (10, 11, 12, 13) rectiligne.

7. Sas à bande selon l'une des revendications 1 à 3,
**caractérisé en ce que** l'un des éléments formant écrans (9) est réalisé sous forme de rouleau.

8. Sas à bande selon l'une des revendications 1 à 7,
**caractérisé en ce qu'**au moins un des éléments formant écrans (6, 7, 8, 9) est poussé avec sa surface d'étanchéité (10, 11, 12, 13) vers la surface de la bande au moyen d'au moins un élément à ressort (18).

9. Sas à bande selon l'une des revendications 1 à 8,
**caractérisé en ce qu'**il est prévu au moins un rouleau de guidage (19), qui est approché de l'arête (20) de la bande et qui guide la bande (4) par rapport au sas à bande (1).

10. Sas à bande selon l'une des revendications 1 à 9,
**caractérisé en ce qu'**au moins un élément formant écran (6, 7, 8, 9) est équipé de moyens (21) pour ajuster la hauteur ou la largeur efficace.

11. Sas à bande selon la revendication 10,
**caractérisé en ce que** les moyens (21) pour ajuster la hauteur ou la largeur efficace sont réalisés par deux parties formant écrans (6', 6"), qui sont appliquées l'une contre l'autre au niveau de surfaces de contact (22, 23) taillées en oblique par rapport à la direction de convoyage (F) de la bande (4), telles que l'une au moins des parties (6', 6") est susceptible d'être positionnée par un élément de déplacement (24) dans la direction de convoyage (F) de la bande (4).

12. Sas à bande selon l'une des revendications 1 à 11,
**caractérisé en ce qu'**il est prévu un moyen d'échange (25), avec lequel un élément formant écran (6, 7, 8, 9) peut être introduit ou extrait perpendiculairement à la direction de convoyage (F) de la bande (4) dans la région d'étanchement.

13. Sas à bande selon l'une des revendications 1 à 12,
**caractérisé en ce que** la bande (4) est guidée en direction de convoyage (F) via deux rouleaux (26, 27) de telle manière qu'il en résulte un renvoi de la bande à deux reprises devant et derrière les éléments formant écrans (6, 7, 8, 9).

14. Sas à bande selon l'une des revendications 1 à 13,
**caractérisé en ce que** plusieurs étages de sas sont agencés les uns derrière les autres dans la direction de transport de la bande.

15. Sas à bande selon l'une des revendications 1 à 14,
**caractérisé en ce qu'**il est employé pour l'étanchement d'un premier espace (2) avec un premier niveau de pression par rapport à un second espace (3) avec un second niveau de pression qui diffère du premier niveau de pression.

16. Sas à bande selon l'une des revendications 1 à 14,
**caractérisé en ce qu'**il est employé pour l'étanchement d'un premier espace (2) avec un milieu de traitement par rapport à un second espace (3) avec un second milieu de traitement qui diffère du premier milieu de traitement.
